# EUROPEAN PATENT APPLICATION

(11) **EP 1 633 000 A1**
(43) Date of publication of application: **08.03.2006**
(21) Application number: 04745809.6
(22) Date of filing: 11.06.2004
(51) Int. Cl.: H01L 27/092, H03D 7/14, H04B 1/30, H01L 29/78, H01L 21/336

(54) **MIXER CIRCUIT**

(30) Priority: 12.06.2003 JP 2003168529
(71) Applicant: KABUSHIKI KAISHA TOYOTA JIDOSHOKKI, Kariya-shi, Aichi-ken 448-8671 (JP); Niigata Seimitsu Co., Ltd., Niigata 943-0834 (JP); OHMI, Tadahiro, Sendai-shi, Miyagi-ken 980-0813 (JP)
(72) Inventor: OHMI, Tadahiro, Sendai-shi, Miyagi 980-0813 (JP); NISHIMUTA, Takefumi, c/o K.K. TOYOTA JIDOSHOKKI, Kariya-shi, Aichi 448-8671 (JP); MIYAGI, Hiroshi, c/o NIIGATA SEIMITSU CO., LTD, Joetsu-shi, Niigata 943-0834 (JP); SUGAWA, Shigetoshi, Sendai-shi, Miyagi 980-0861 (JP); TERAMOTO, Akinobu, Sendai-shi, Miyagi 983-0037 (JP)
(74) Representative: TBK-Patent
(86) International application number: PCT/JP2004/008215
(87) International publication number: WO 2004/112140

(57) **Abstract**

A mixer circuit is configured using a CMOS transistor (800), comprising a p-channel transistor (840A) and an n-channel transistor (840B) in which semiconductor substrates (810A, 810) with at least two crystal planes and a gate insulator (820A) formed on at least two of the crystal planes on the semiconductor substrate are comprised and the channel width of a channel formed in the semiconductor substrate along with the gate insulator is represented by summation of each of the channel widths of channels individually formed on said at least two crystal planes. Such a configuration allows reduction of 1/f noise, DC offset generated in output signals due to variation in electrical characteristics of a transistor element, and signal distortion based on the channel length modulation effect.

## Description

### Technical Field

The present invention relates to a mixer circuit configured on a MIS integrated circuit.

### Background Art

A direct conversion receiving system is a well known technique for extracting a desired wave from a radio frequency (RF) signal.
In such a receiving system, the carrier frequency is directly converted into a base band frequency without a mediating intermediate frequency (IF).

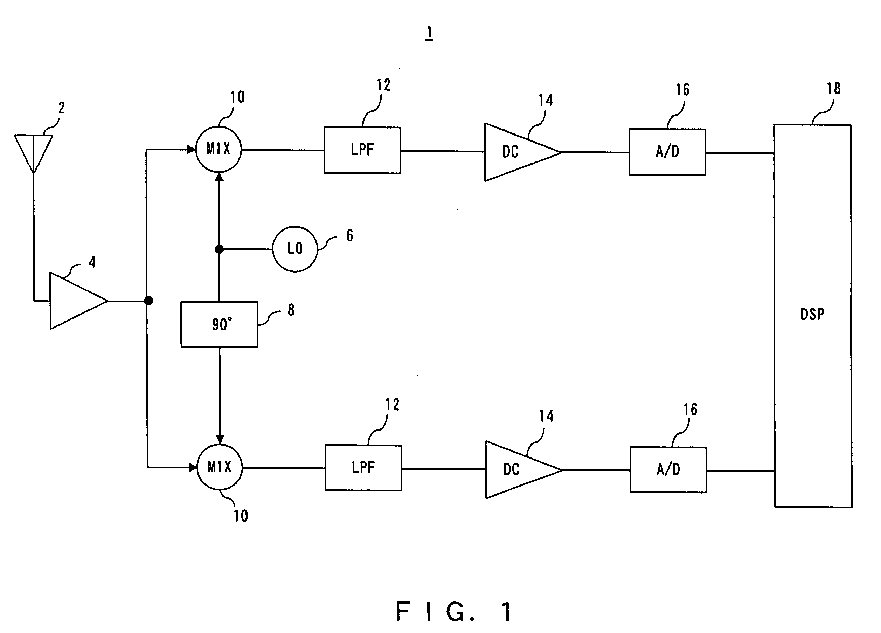

Fig. 1 is a circuit block diagram showing a commonly used direct conversion receiving system. A circuit block diagram 1 in Fig. 1 comprises an antenna 2, a low noise amplifier (LNA) 4, a local oscillator 6, a 90-degree phase shifter 8, a mixer 10, a low-pass filter (LPF) 12, a DC amplifier 14, an A/D converter 16 and a DSP 18.

Upon receiving an RF signal from the antenna 2 in Fig. 1, the RF signal is amplified by the LNA 4, and the amplified RF signal is provided to the mixers 10 configured at the top and bottom of Fig. 1.
Also, a local (LO) signal with the same frequency as the above RF signal is output from the local oscillator 6, and LO signals are input to each mixer 10 with each having a phase different from the other of 90-degrees due to the 90-degree phase shifter 8.

In the mixer 10, the above input RF signal and LO signal are multiplied, and outputs of the LNA 4 are converted into base band signals with an in-phase (I) element and a quadrature (Q) element. According to this system, because the IF is zero and the base band signals piles up and cannot be demodulated, quadrature demodulation is performed using the two LO signals with their phases different from each other by 90-degrees and two units of mixers 10 as explained above.

The signals output from the mixers 10, in the lower stage, have unnecessary frequencies cut by the LPF 12, the desired wave output from the LPF 12 is amplified by a DC amplifier 14, and the output signal from the DC amplifier 14 is converted into a digital signal by the A/D converter 16.

By inputting the digital signal converted by the A/D converter 16 to the DSP 18, processing such as code regeneration is performed.
In this receiver system, because carrier frequency is directly converted into a base band frequency without a mediating intermediate frequency (IF), image frequency does not exist in principle.

Thus, as clearly shown in Fig. 1, it is possible, in the direct conversion receiving system, to eliminate some components such as a band-pass filter for removing image frequencies and an intermediate frequency filter for band limiting to extract intermediate frequencies, used in a known super heterodyne receiving system in which a carrier frequency is converted into a base band frequency mediating an intermediate frequency (IF). Therefore, the present receiving system is the best for downsizing receivers, and there is great expectation for future technical innovation.

In the receiving system, the mixer circuit 10 is configured as an upper stage circuit, and required to obtain high-quality output signal so that the output signal does not cause an adverse effect on the circuits of following stages.
Meanwhile, in recent years, the problem of low speed and the problem of large noise are being improved in the technical field of MOS (Metal-Oxide-Semiconductor) transistors, and semiconductor devices with characteristic configurations of MOS transistors are found frequently. As one of such semiconductor devices, Japanese laid-open disclosure public patent bulletin No. 2002-110963 discloses a configuration example of a semiconductor device comprising a single MOS transistor of a single conductivity type (p-channel or n-channel) on a semiconductor substrate.

In the disclosed MOS transistor, the thermal-oxidation processed gate insulator of the MOS transistor is configured on the surface of a projecting part of a semiconductor substrate and a channel can be formed on the sidewall of the projecting part of the semiconductor substrate.

In such a manner, since the past, mixer circuits have been challenged to have a high-quality output signal and to be integrated on a semiconductor substrate, and improvements have been made.
Patent Document 1: Japanese laid-open disclosure public patent bulletin No. 2003-134183
Patent Document 2: Japanese laid-open disclosure public patent bulletin No. 2002-110963

However, contrary to the above advantage of reduction in the number of components, a problem arises when adopting the above direct conversion receiving system, for example.

The problem is degradation of quality of a demodulated signal due to the occurrence of a DC offset and noise etc.
In the direct conversion receiving system, because the frequency of the RF signal received by the antenna and that of the LO signal output from the local oscillator are the same, if the LO signal leaks in the RF signal path, self-mixing of the LO signals in the mixer causes a DC offset. The DC offset can be caused by variation in electrical characteristics of transistor elements constituting the mixer. The transistor elements, which are a cause of the DC offset, are transistors in a differential pair configuration, and the DC offset is caused when electrical characteristics of the transistors in a pair fail to agree with one another.

Unlike the above super heterodyne receiving system, which usually acquires gain in the IF amplifier stages, in the direct conversion receiving system, most of the gain has to be acquired in a base band signal processing unit. This system raises problems, such as when the signal is amplified in the base band processing unit, signal level on the whole is shifted up by the DC elements and the dynamic range of the A/D converter cannot be used effectively.

In the saturation region of the transistor characteristics, it is desirable that drain current indicates a constant value without depending on the voltage between the drain and the source; however in practice, the channel length modulation effect, in which an effective gate length is reduced whereas drain current is increased, occurs by shift of a pinch-off point (a point where channel carrier density becomes approximately 0) in the saturation region. This effect makes it more difficult to obtain a stable signal without distortion in the mixed signal.

Additionally, for the above super heterodyne receiving system acquiring gain in the IF amplifier stages, problems are resistance used in the circuit or transmission line loss, electrode wiring resistance of a transistor in use or thermal noise caused by resistance etc. of a semiconductor layer; however, in the direct conversion receiving system of which most of the gain is acquired in the base band signal processing unit, low-frequency noise also becomes a problem.

This low-frequency noise is flicker noise (1/f noise) from a transistor constituting the mixer generated by generation or recombination of electron-hole pairs, capture of a carrier in a trap, or release of a carrier from a trap etc. at the surface/interface.

As described above, a mixer circuit has various causes of deterioration of the demodulated signal, and thus miniaturization of a mixer circuit and improvement of the quality of a mixed signal output from the mixer circuit were problems to be solved.

### Disclosure of the Invention

It is an object of the present invention to provide a mixer circuit, which enables improvement of the quality of a mixed signal output, and the circuit has the following configuration.
One mode of the mixer circuit of the present invention is assumed to comprise of at least a pair of differential pair transistors for inputting a first frequency signal or a second frequency signal and generating a third frequency signal by multiplying the first frequency signal and the second frequency signal, and each transistor of the differential pair transistors is a MIS (Metal-Insulator-Semiconductor) transistor comprising a semiconductor substrate for comprising a first crystal plane (a (100) plane, for example) as a principal plane, a semiconductor structure, formed as a part of the semiconductor substrate, for comprising a pair of sidewall planes defined by the second crystal plane (a (110) plane, for example) different from the first crystal plane and a top plane defined by the third crystal plane (for example a (100) plane or a (111) plane, preferably the same crystal plane as the first crystal plane) different from the second crystal plane, a gate insulator for covering the principal plane, the sidewall planes and the top plane of uniform thickness, a gate electrode for continuously covering the principal plane, the sidewall planes and the top plane over the gate insulator, and a single conductivity type diffusion region formed in one side and the other side of the gate electrode in the semiconductor substrate and the semiconductor structure and continuously extending along the principal plane, the sidewall planes and the top plane.

Another mode of the mixer circuit of the present invention is assumed to comprise at least a pair of differential pair transistors for inputting a first frequency signal or a second frequency signal and generating a third frequency signal by multiplying the first frequency signal and the second frequency signal, and each transistor of the differential pair transistors is a MIS transistor comprising a semiconductor substrate comprised of a projecting part with at least two different crystal planes (for example, the (100) plane and the (110) plane, the (100) plane and the (111) plane, the (110) plane and (111) plane, or the (100) plane, the (110) plane and the (111) plane) on the surface of a principal plane, a gate insulator for covering at least a part of each of said at least two different crystal planes constituting the surface of the projecting part, a gate electrode comprised by the gate insulator so as to be electrically insulated from the semiconductor substrate, and comprised on each of said at least two different crystal planes constituting the surface of the projecting part and a single conductivity type diffusion region formed in the projecting part facing each of said at least two different crystal planes constituting the surface of the projecting part and individually formed in both sides of the gate electrode.

Another mode of the mixer circuit of the present invention is assumed to comprise at least a pair of differential pair transistors for inputting a first frequency signal or a second frequency signal and generating a third frequency signal by multiplying the first frequency signal and the second frequency signal, and each transistor of the differential pair transistors is a three dimensional structure MIS transistor, comprising a semiconductor substrate comprising at least two crystal planes, a gate insulator formed on at least two of the crystal planes of the semiconductor substrate and a gate electrode formed on the semiconductor substrate sandwiching the gate insulator, in which when voltage is applied to the gate electrode, the channel width (a channel width in a direction perpendicular to the movement of carriers of electrons and holes etc. and in a direction along the gate insulator) of a channel formed in the semiconductor along with the gate insulator is represented by summation of each channel width (a channel width in a direction perpendicular to the movement of carriers of electrons and holes etc. and in a direction along the gate insulator) of the channels individually formed on said at least two crystal planes.

In each of the above modes, it is desirable that the MIS transistor is comprised such that the semiconductor substrate is a silicon substrate and that a gate insulator on a surface of the silicon substrate, is formed by removing hydrogen in such a way that the surface of the silicon substrate is exposed to a plasma of a prescribed inert gas, and the hydrogen content at the interface of the silicon substrate and the gate insulator is 10¹¹/cm² or less in units of surface density.

In each of the above modes, it is also desirable that the said at least two crystal planes are any two different crystal planes from the (100) plane, the (110) plane and the (111) plane.

Additionally, in each of the above modes, it is desirable that the mixer circuit is a Gilbert cell type circuit.
In each of the above modes, furthermore, it is desirable that the circuit configuration of the mixer circuit uses the MIS transistors symmetrically.

The mixer circuit of the above modes may be used as a receiver for the first frequency signal, which is a high-frequency signal, the second frequency signal, which is a local signal, and the third frequency signal, which is a low-frequency signal. It is also used in a direct conversion receiving system where the low-frequency signal is a base band signal.

Further, in a mixer circuit, comprising a CMOS transistor configured in an n-channel MOS transistor and a p-channel MOS transistor, at least one of the n-channel MOS transistor or the p-channel MOS transistor comprises the MIS transistor of any one mixer circuit of the above modes.

In such a case, it is desirable that element area and the current driving capacity of the p-channel MOS transistor and the n-channel MOS transistor closely agree with each other.
In the mixer circuit of the present invention, a gate width is formed along said at least two different crystal planes. Therefore, when voltage is applied to the gate, channels are formed along with said at least two different crystal plane. And when channels are formed along with the crystal plane of the projecting part in particular, the gate length modulation effect generated in each transistor can be well controlled.

The MIS transistor is characterized in that the semiconductor substrate is a silicon substrate and that a gate insulator on a surface of the silicon substrate is formed by removing hydrogen in such a way that the surface of the silicon substrate is exposed to a plasma of a prescribed inert gas, and the hydrogen content at an interface of the silicon substrate and the gate insulator is 10¹¹/cm² or less in units of surface density, and for this reason, the Dit at midgap of the interface of the semiconductor substrate and the gate insulator can be lowered, and reduction of the 1/f noise and variation in electrical characteristics of each transistor can be achieved.

In addition, at least two of the crystal planes by combining any two different crystal planes from the (100) plane, the (110) plane and the (111) plane at least two of the crystal planes substantially reduce the 1/f noise and variation in electrical characteristics.

By configuring the transistors in a differential pair configuration, external noise can also be eliminated.
A symmetrical circuit can be configured by the transistor so that a signal output from the mixer circuit is a favorable and stable signal.

When the mixer circuit is applied to a direct conversion receiving system, dynamic range can be effectively utilized in an A/D converter configured in a later stage of the mixer circuit.
Moreover, a mixer circuit, comprising a CMOS (Complementary Metal Oxide Semiconductor) transistor in which current driving capacity and element area of an n-channel MOS transistor agrees with those of a p-channel MOS transistor, can be configured.

### Brief Description of the Drawings

The present invention will be more apparent from the following detailed description in conjunction with the accompanying drawings, in which:
Fig. 1 is a circuit block diagram of a conventional direct conversion receiving system;
Fig. 2 is a cross-sectional diagram showing an example of a plasma processing device 100 using a radial line slot antenna;
Fig. 3 is an analysis result of silicon-hydrogen bonding on a silicon substrate 103 by an infrared spectrograph;
Fig. 4 is the relationship between pressure in a processing chamber and thickness of an oxide film formed when gas pressure in the processing chamber 101 is varied while keeping the pressure ratio of Kr/O₂ at 97/3 in the processing chamber;
Fig. 5 is a diagram comparing the growth rate of a Kr/O₂ plasma oxide film with the growth rate of a dry thermal oxide film;
Fig. 6 is a diagram comparing the Dit at midgap of the Kr/O₂ plasma oxide film with that of the dry thermal oxide film;
Fig. 7A shows drain voltage versus normalized drain current characteristic;
Fig. 7B shows drain voltage versus normalized drain current characteristic;
Fig. 7C shows drain voltage versus normalized drain current characteristic;
Fig. 8 is an example of a configuration of an n-channel MOS transistor;
Fig. 9 is an example of a configuration of a CMOS transistor;
Fig. 10 is a diagram of a part extracted from Fig. 8;
Fig. 11A is a diagram showing an example of a mixer circuit;
Fig. 11B is a diagram showing an example of the mixer circuit; and
Fig. 12 is a circuit block diagram of the direct conversion receiving system of the embodiment of the present invention.

### Best Mode for Carrying Out the Invention

In the following description, details of a preferred embodiment of the present invention are set forth with reference to the accompanying drawings.
A mixer circuit of a preferred embodiment of the present invention is comprised of transistors of MIS (Metal-Insulator-Semiconductor) structure. In the embodiment of the present invention, a gate insulator of the MIS transistor is formed by adopting a gate insulator thin film formation technique, which is disclosed in Japanese laid-open unexamined patent publication No. 2002-261091.

For the above gate insulator, a nitride film or an oxynitride film can be used as described in the Japanese laid-open unexamined patent publication No. 2002-261091; however, the present embodiment is explained taking an example of a MOS (Metal-Oxide-Semiconductor) transistor (MOSFET etc., for example) with the gate insulator as its oxide film.

First, an explanation of a gate insulator thin film formation method of the MOS transistor is provided.

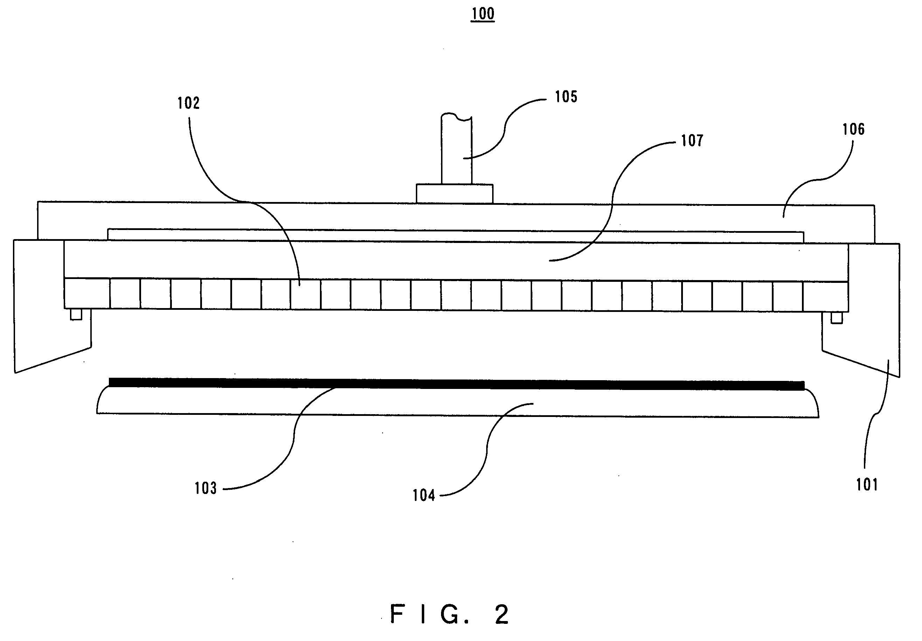

Fig. 2 is a cross-sectional diagram showing an example of a plasma processor device 100 using a radial line slot antenna.

In the gate insulator thin film formation method, in order to remove hydrogen terminating the dangling bonds of the silicon (indicated as Si) surface, surface terminating hydrogen removal processing and oxidation processing are carried out sequentially in the same processing chamber using Kr as a plasma excitation gas in the subsequent oxide film formation process.

First, avacuumvessel (processing chamber) 101 is evacuated, Ar gas is introduced into the vessel from a shower plate 102, and later the introduced gas is changed to Kr gas. Air pressure in the vacuum processing chamber 101 is set around 133 Pa (1 Torr).

Next, a silicon substrate 103 is placed on a sample holder 104 with a heating mechanism and the temperature of the sample is set around 400°C. If the temperature of the silicon substrate 103 falls within the range of 200-550°C, the result described below will be almost the same. The silicon substrate 103 is treated with diluted hydrofluoric acid cleaning in the immediately preceding pretreatment processing step, and as a result, the dangling bonds of silicon on the surface are terminated with hydrogen.

Next, 2.45GHz microwaves are provided from a coaxial waveguide 105 to a radial line slot antenna 106, and microwaves are emitted in the processing chamber 101 from the radial line slot antenna 106 via a dielectric plate 107 configured on a part of the wall of the processing chamber 101. The emitted microwaves excite the Kr gas introduced from the shower plate 102 into the processing chamber 101, and high-density Kr plasma is formed directly below the shower plate 102. If the frequency of the provided microwaves is approximately within the range from 900MHz to 10GHz, the results explained below are almost the same.

In the configuration shown in Fig. 2, the distance between the shower plate 102 and the substrate 103 is set at 6cm in the present embodiment. A shorter distance between the two enables higher speed film formation.
Although the present embodiment shows an example of film formation using a plasma device with a radial line slot antenna, other methods can be used to excite plasma by emitting microwaves within the processing chamber.

By exposing the silicon substrate 103 to the plasma excited by the Kr gas, the surface of the silicon substrate 103 receives low-energy Kr ion irradiation, and the terminating hydrogen on the surface is removed.

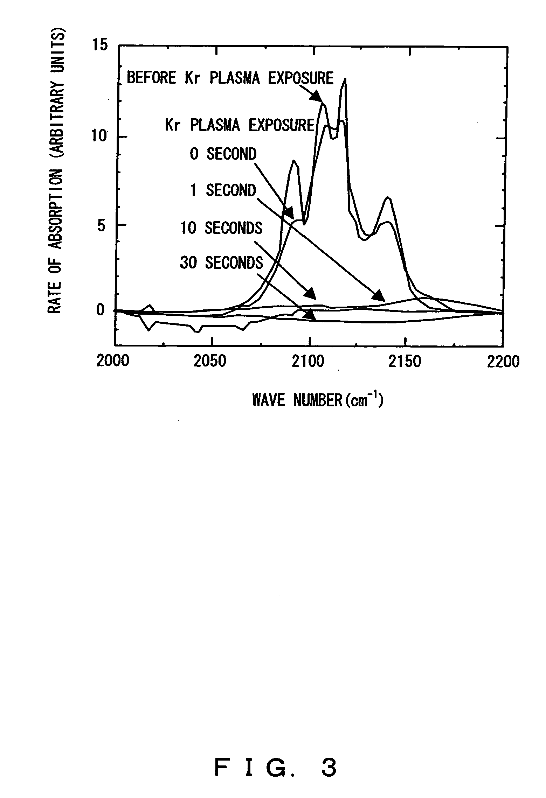

Fig. 3 shows a result of analysis of silicon-hydrogen bonding on the silicon substrate surface by an infrared spectrograph, and shows the removal effect of the terminating hydrogen on the silicon surface by the Kr plasma excited by emitting microwaves with a power density of 1.2W/cm² under 133 Pa (1 Torr) pressure in the processing chamber 101.

Reference to Fig. 3 discloses that only 1 second of Kr plasma irradiation causes most of the optical absorption in the vicinity of a wave number of 2100cm⁻¹, which is a characteristic of the silicon-hydrogen bond, to disappear, and with approximately 30 seconds of irradiation, the optical absorption disappears almost completely. In other words, approximately 30 seconds of Kr plasma irradiation can remove hydrogen terminating the silicon surface. In the present embodiment, Kr plasma irradiation is continued for 1 minute and completely removes the terminating hydrogen on the surface.

Next, a Kr/O₂ gas mixture with a partial pressure ratio of 97/3 is introduced from the shower plate 102. In so doing, the pressure in the processing chamber is maintained at around 133 Pa (1 Torr). In high-density excitation plasma in which Kr gas and O₂ gas are mixed, Kr*, which is in an intermediate excitation state, and O₂ molecules collide, effectively generating a large amount of atomic oxygen O*.

In the present embodiment, the surface of the silicon substrate 103 is oxidized by this atomic oxygen O*. The use of the present thin film formation method enables oxidation processing by the atomic oxygen at the significantly low temperature of around 400°C. In order to increase the chance of Kr*-O₂ collisions, it is desirable for the processing chamber to have a high pressure; however, if it is too high, the generated O* collide with one another and become O₂ molecules again. Therefore, there is an optimal gas pressure.

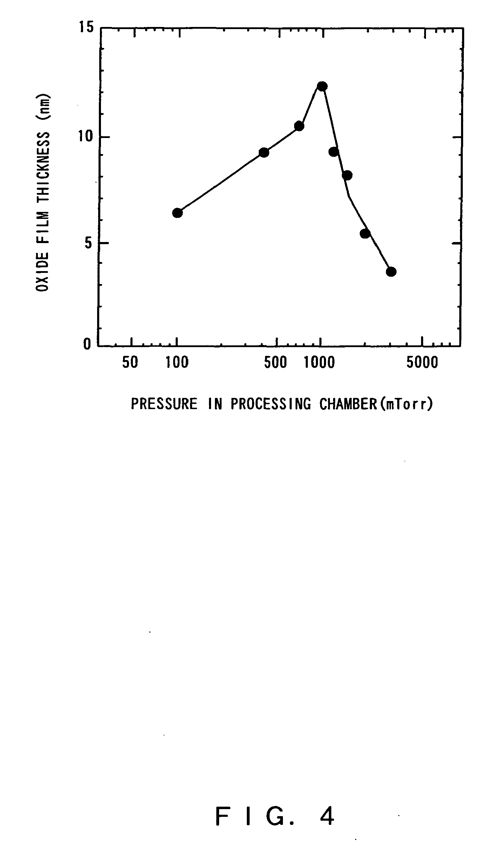

Fig. 4 shows the relationship between the thickness of the formed oxide film and the pressure in the processing chamber in a case where, maintaining the pressure ratio of Kr/O₂ at 97/3 within the processing chamber, the gas pressure within the processing chamber 101 is changed. In Fig. 4, the temperature of the silicon substrate 103 is set at 400°C, and the oxidation processing is carried out for 10 minutes.

Reference to Fig. 4 reveals that the oxidation rate is highest when the pressure within the processing chamber 101 is around 133 Pa (1 Torr), and thus this pressure or pressure conditions around this pressure are optimal. The optimal pressure is not limited to the case that the plane orientation of the silicon substrate 103 is the (100) plane, but is the same for any silicon surface with any plane orientation.

When silicon oxide film of a desired film thickness is formed, application of microwave power is stopped and then the plasma excitation is terminated. Additionally, the Kr/O₂ gas mixture is replaced by Ar gas, and then the oxidation process is completed. The Ar gas is used before and after the present process as a purge gas, which is less costly than Kr. The Kr gas used for the present process is to be recovered and recycled.

Following the above Kr/O₂ plasma oxide film formation, a semi-conductor integrated circuit device comprising a MOS transistor and a capacitor can be completed after an electrode formation process, a protective film formation process, and a hydrogen sintering processing process etc.

When the hydrogen content in units of surface density within a 3nm thick silicon oxide film formed by the above procedure was measured by thermal desorption analysis, the results were around 10¹²/cm² or less. It is confirmed that the hydrogen content in units of surface density within the silicon oxide film is around 10¹¹/cm² or less in an oxide film with particularly low leakage current. On the other hand, the oxide film, which was not exposed to the Kr plasma before the oxide film formation contained hydrogen at over 10¹²/cm² in units of surface density.

Measurement of roughness of a silicon surface after exfoliating the silicon oxide film formed by the above procedure, by an atomic force microscope and comparison with that of silicon roughness before oxide film formation confirmed that the roughness of the silicon surface remains unchanged. In other words, the silicon surface does not increase in roughness after removal of terminating hydrogen and oxidation.

According to the present gate insulator thin film formation method, hydrogen, remaining at the interface between a silicon substrate and a silicon oxide film formed as the gate insulator of a MOS transistor, is removed, and the interface is flattened. By such flattening, a low Dit at midgap at the interface can be attained, and favorable electrical characteristics (low leakage current characteristics, low Dit at midgap, high voltage resistance, high hot carrier resistance, constant threshold voltage characteristics etc.) can be acquired even though the gate insulator is thinned. Additionally, in the case of a gate insulator with an arbitrary plane orientation, favorable electrical characteristics can still be acquired from the plane orientation.

Next, an example of a MOS transistor formation using not only the (100) plane but also the (111) plane and the (110) plane of a silicon substrate in the above gate insulator thin film formation method is described.

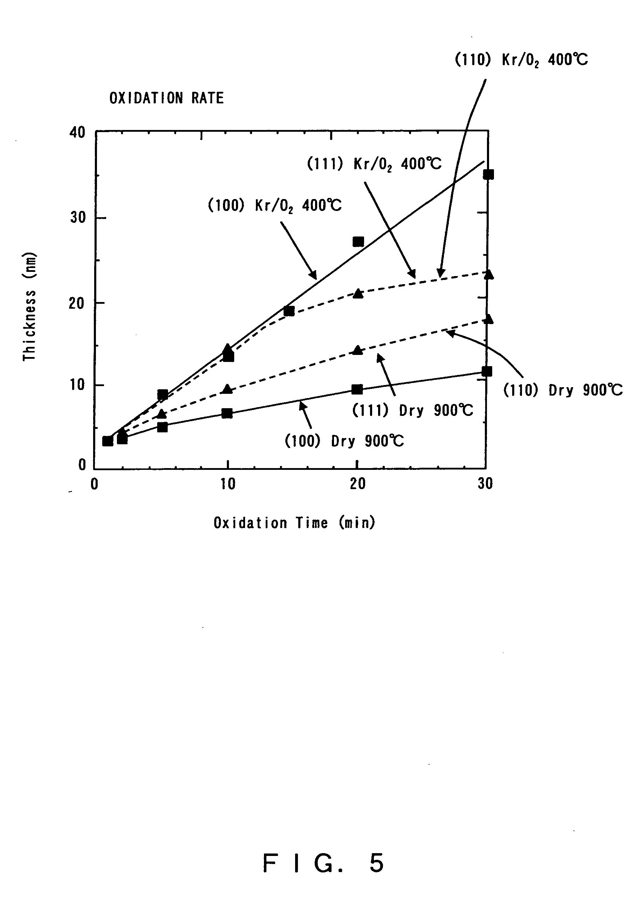

Fig. 5 shows the growth rate of a Kr/O₂ plasma oxide film, when oxidizing the (100) plane, the (111) plane and the (110) plane of a silicon substrate with the plasma processing device 100 of Fig. 2, in comparison with growth rates of a dry thermal oxide films.

Reference to Fig. 5 shows that the Kr/O₂ plasma oxide film yields a much higher growth rate than the dry thermal oxide film, oxidation of an Si substrate using active atomic oxygen O* proceeds efficiently. In addition, it is understood from Fig. 5 that for the (111) plane and (110) plane, of which the Si atom surface density is greater than the (100) plane, a lower growth rate is yielded than for the (100) plane. This is in agreement with the conclusion derived from the material supply rate determining process; therefore the result suggests that the plasma oxide film formed in such a manner has a superior film quality.

Conversely, when forming dry thermal oxide films on the (111) and the (110) planes of Si substrate, the growth rate of the oxide film is higher than the growth rate when forming a dry thermal oxide film on the (100) plane, suggesting that the film quality of the dry thermal oxide film formed on the (111) plane and the (110) plane is inferior.

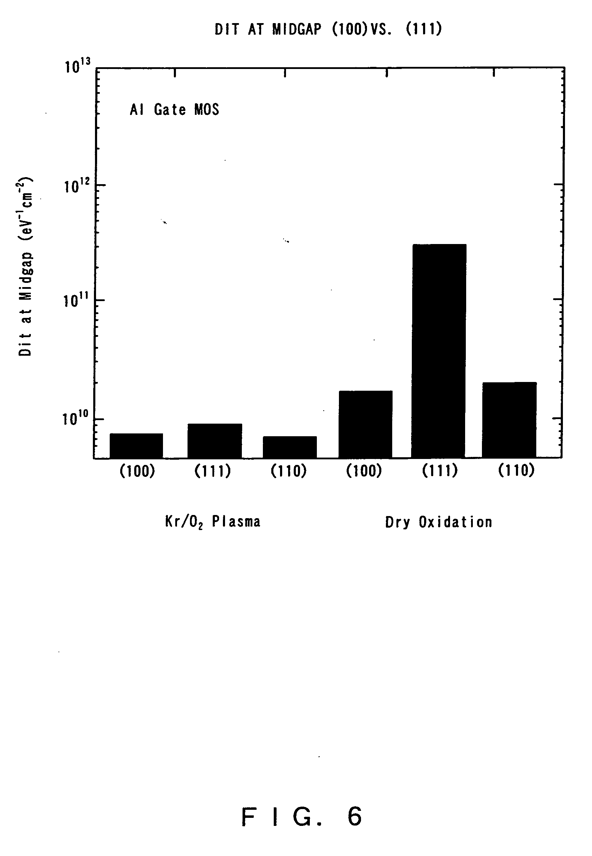

Fig. 6 shows comparison results of Dit at midgap of the Kr/O₂ plasma oxide film formed as above and that of dry thermal oxide films.
Reference to Fig. 6 discloses that the Dit at midgap of the Kr/O₂ plasma oxide film formed on the (100) plane of a silicon and the Kr/O₂ plasma oxide film formed on the (111) plane of a silicon surface and the (110) plane of a silicon are all lower than those of the dry thermal oxide film formed on the (100) plane of a silicon, and an oxide film with extremely high quality can be acquired.

Conversely, a dry thermal oxide film formed on the (111) plane of a silicon and the (110) plane of a silicon has extremely high Dit at midgap as predicted from the result in Fig. 5, and it is possible that various problems may be caused such as change in threshold voltage by carrier capture and increase in gate leakage current when used as a gate insulator of an MOS transistor.

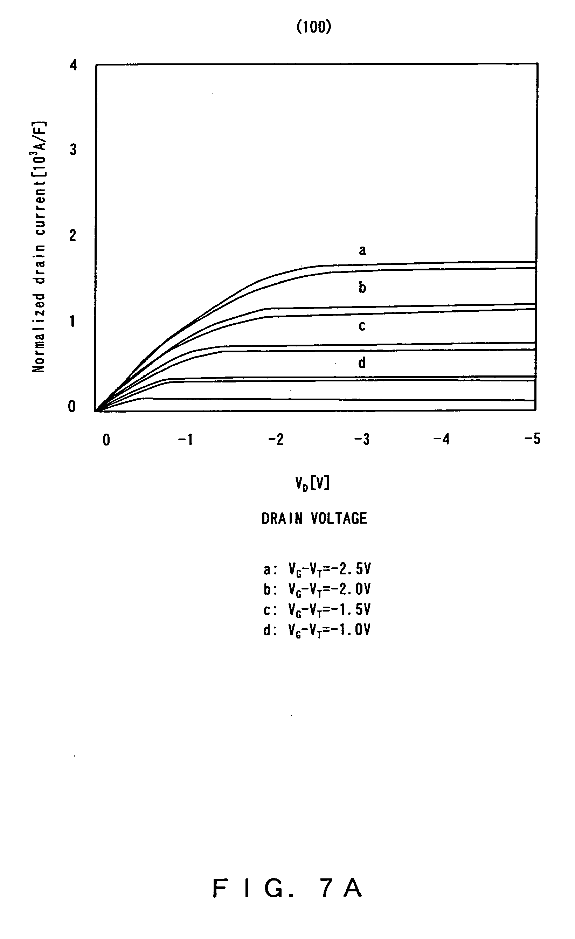

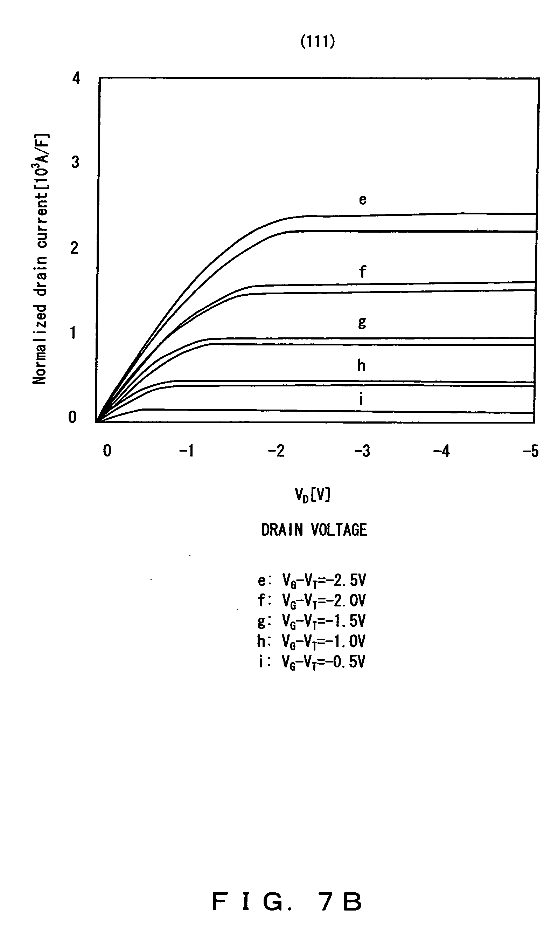

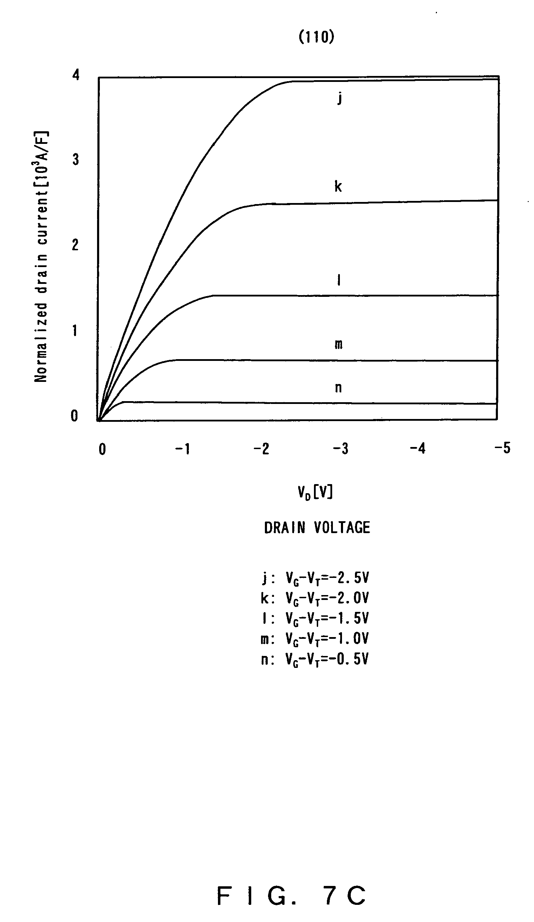

The Fig. 7A-Fig. 7C show the relationships between the drain voltage and the normalized drain current when a silicon oxide film is formed on the (100) plane of a silicon substrate, the (111) plane of a silicon substrate and the (110) plane of a silicon substrate, respectively, by the plasma processing device 100 of Fig. 2 and a p-channel MOS transistor with the silicon oxide film as a gate insulator is formed. Fig. 7A and Fig. 7B show both the cases where silicon oxide film is formed by Kr/O₂ plasma processing and where silicon oxide film is formed by dry thermal oxidation processing. In Fig. 7C, however, because an oxide film is not formed on the (110) plane by the dry thermal oxidation process, only the example of a gate oxide film formed by the Kr/O₂ plasma processing is shown. The result of Fig. 7A is of a p-channel MOS transistor with a gate length of 10µm and a gate width of 50µm, and the results in Fig. 7B and Fig. 7C are of a p-channel MOS transistor with a gate length 10µm and a gate width of 300µm.

Reference to Fig. 7A-Fig. 7C show that it is possible to increase the drain current of the p-channel MOS transistor, that is mutual conductance or current driving capacity, by forming a transistor on any crystal surface except for the (100) plane of a silicon such as the (111) plane or the (110) plane, to acquire a current driving force of about 1.3 times as much as that of the p-channel MOS transistor formed on the (100) plane when the p-channel MOS transistor is formed on the (111) plane of a silicon, and to acquire a current driving force of about 1.8 times as much as that of the p-channel MOS transistor formed on the (100) plane when the p-channel MOS transistor is formed on the (110) plane of a silicon.

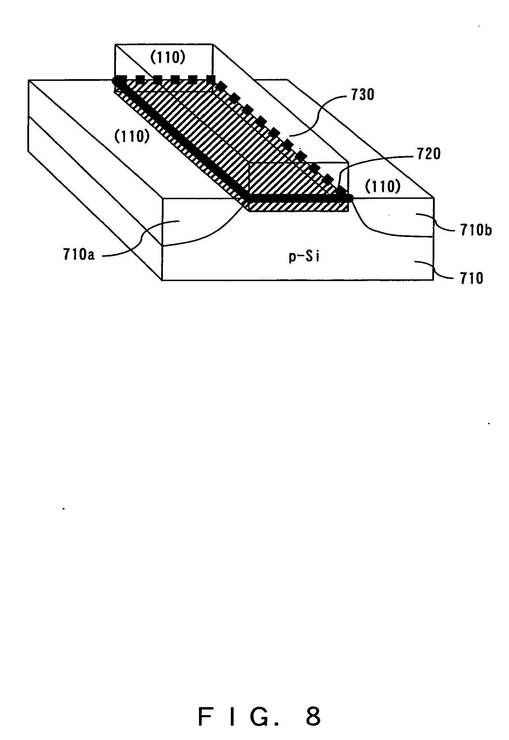

Fig. 8 is an example of a configuration of an n-channel MOS transistor.
The n-channel MOS transistor shown in Fig. 8 has a silicon oxide film evenly formed on the surface of a Si substrate 710 with a principal plane of the (110) plane, by the plasma processing device 100 explained in Fig. 2, and a polysilicon gate electrode 730 is produced on the formed silicon oxide film. Patterning is applied to the silicon oxide film along with patterning of the gate electrode 730, and a gate insulator 720 is formed in a region surrounded by the bold line and the broken line corresponding to the gate insulator 730 in Fig. 8.

The n-type diffusion regions 710a and 710b are formed on both sides of the gate electrode 730 by performing ionic implantation of an n-type impurity using the gate electrode 730 as self-aligning mask. As a result, an n-channel MOS transistor is formed on the Si substrate 710. In Fig. 8, when a channel is formed between the n-type diffusion regions 710a and 710b, the range of the formation is indicated by the shaded area.

Fig. 8 is an example of a configuration of an n-channel MOS transistor; however by forming p-type diffusion regions on both sides of the gate electrode by performing ionic implantation of a p-type impurity using the gate electrode as self-aligning mask, a p-channel MOS transistor can be formed on a Si substrate.

In the MOS transistor configured as above, low Dit at midgap can be acquired at interface of the Si substrate and the gate oxide film; therefore 1/f noise can be reduced, and favorable electrical characteristics can be stably acquired. For that reason, a more stable MOS transistor with reduced variation in electrical characteristics between elements can be configured.

In the above configuration example, a transistor was formed on the (110) plane of a Si substrate; however when the transistor is formed on other plane such as the (100) plane and the (111) plane the above effect can still be obtained.
Next, unlike the case of configuring a transistor only on one orientation such as the (110) plane, an example of configuring a transistor (three-dimensional structure) using a plurality of orientations simultaneously is described.

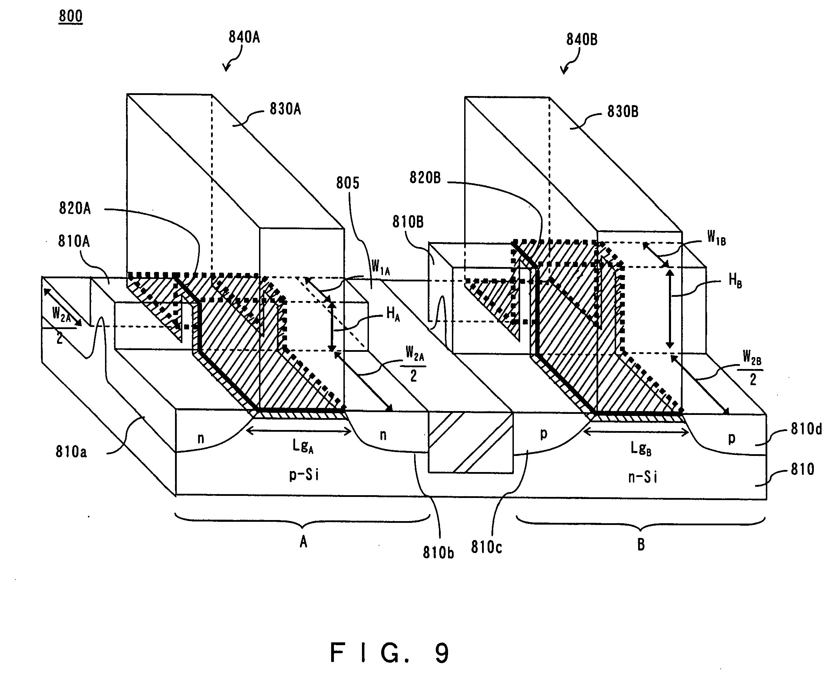

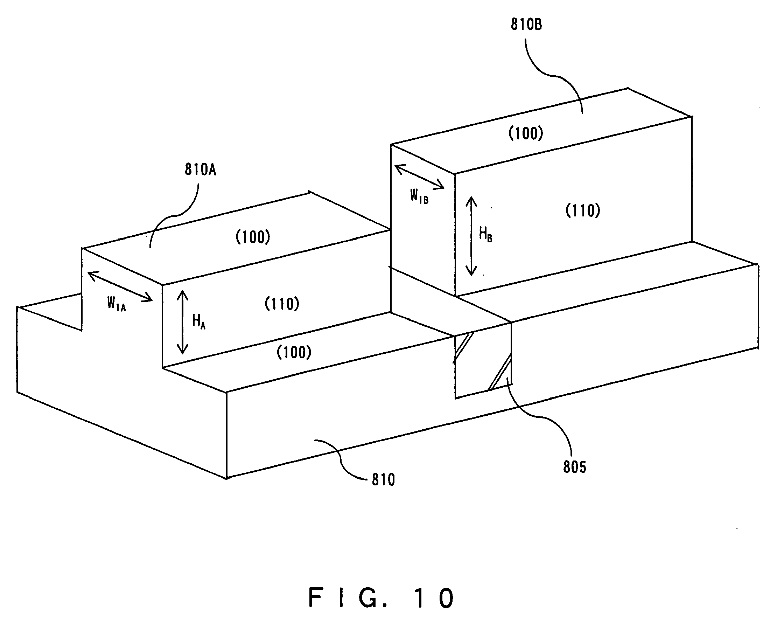

Fig. 9 and Fig. 10 are an example of a CMOS (Complementary Metal Oxide Semiconductor) transistor comprising a p-channel MOS transistor and an n-channel MOS transistor.

Fig. 10 is a diagram extracted from a part of Fig. 9.
Reference to Fig. 9 and Fig. 10 shows that a CMOS transistor 800 is formed on a Si substrate 810, having a principal plane of the (100) plane where a n-type region A and a p-type region B, separated by a element separation region 805, are formed, and as shown in Fig. 10, the region A, comprising a projecting part 810A with a width of W_{1A} and a height of H_{A}, and the region B, comprising a projecting part 810B with a width of W_{1B} and a height of H_{B}, are formed on the walls of both sides. As can be seen from Fig. 10, the top surface of the projecting parts 810A and 810B is defined by the (100) plane and the side surface is defined by the (110) plane.

A silicon oxide film is evenly formed on the Si substrate 810 in Fig. 10 by the plasma processing device 100 described in Fig. 2, and on top of the film, polysilicon gate electrodes 830A and 830B shown in Fig. 9 are formed on the region A and on the region B, respectively. Following patterning of the gate electrodes 830A and 830B, patterning is applied to the silicon oxide film, a gate insulator 820A corresponding to the gate electrode 830A and a gate insulator 820B corresponding to the gate electrode 830B are formed in the shaded areas surrounded by a bold line in Fig. 9.

Additionally, in the CMOS transistor 800 in Fig. 9, by performing ionic implantation of the n-type impurity using the gate electrode 830A as a self-aligning mask in the n-type region A, n-type diffusion regions 810a and 810b having the projecting part 810A are formed on both sides of the gate electrode 830A. Similarly, in the p-type region B, p-type diffusion regions 810c and 810d having the projecting part 810B are also formed on both sides of the gate electrode 830B. As a result, on the Si substrate 810, an n-channel MOS transistor 840A is produced in the region A and a p-channel MOS transistor 840B is produced in the region B.

In the CMOS transistor 800 described in the present embodiment, the n-channel MOS transistor 840A has a gate length L_{gA} and the p-channel MOS transistor 840B has a gate length L_{gB}, the gate electrode 830A covers a flat part of the Si substrate 810 ateither side of the projecting part 810A over a gate width of W_{2A}/2. As a result, the gate width on the (100) plane of the gate electrode 830A, including the top part of the gate on the projecting part 810A, can be expressed as W_{1A}+W_{2A}. On the other hand, the gate width on the (110) plane of the gate electrode 830A formed on both side walls is expressed by 2H_{A}, and accordingly, the current driving capacity of the n-channel MOS transistor 840A formed on the region A is expressed by the equation µₙ₁(W_{1A}+W_{2A})+2µₙ₂H_{A}, where µₙ₁ represents the electron mobility of the (100) plane and µₙ₂ represents the electron mobility of the (110) plane.
In a similar way, the current driving capacity of the p-channel MOS transistor 840B, formed on the region B, can be expressed by the equation µₚ₁ (W_{1B}+W_{2B}) +2µₚ₂H_{B}, where µₚ₁ represents the hole mobility of the (100) plane and µₚ₂ represents the hole mobility of the (110) plane.

In addition to the (100) plane, which is the principal plane of the Si substrate 810, a gate can be produced on a different plane orientation, that is the (110) plane, as described above; therefore, it is possible to reduce the element area by reducing the gate width of the principal plane, compensating by adjusting the gate width of the part of the gate with a principal plane formed on the (110) plane. Consequently, it is possible to reduce the size of a transistor element.

In the above example, the transistor on the sidewall is formed on both sides of the wall; however it may be formed only on one side.
A configuration with the above H_{A} of 0 is also possible.

In Fig. 9, ranges where channels are formed along with each of the gate insulators 820A and 820B between the n-type diffusion regions 810a and 810b, or between the p-type diffusion regions 810c and 810d on top of the Si substrate are indicated as shaded areas. As is clear from Fig. 9, the width of the channel formed in the Si substrate along with the above gate insulator obeys the summation of the above W_{1A}+W_{2A} of the (100) plane and 2H_{A} of the (110) plane in the case of the n-channel MOS transistor 840A, for example, or obeys the summation of the above W_{1B}+W_{2B} of the (100) plane and 2H_{B} of the (110) plane in the case of the p-channel MOS transistor 840B, for example.

Therefore, if H_{A} and H_{B} are determined so as to satisfy the equations of W_{1A}+W_{2A}=W_{1B}+W_{2B} and µₙ₁ (W_{1A}+W_{2A}) +2µₙ₂H_{A}=µₚ₁ (W_{1A}+W_{2B}) +2µₚ₂H_{A}, it is possible to configure a CMOS transistor with a n-channel MOS transistor and a p-channel MOS transistor such that their element area and current driving capacity agree.

Three-dimensional structure formation of the channels, as shown in the shaded area of Fig. 9, allows control of reduction of the effective gate length based on the shift of the pinch-off point (the point where the channel carrier density becomes approximately 0) in channels formed on one plane and increase of the drain current in the saturation region.

As a result, signal distortion of a signal amplified by an MOS transistor can be reduced.
The embodiment shows an example of a configuration of a CMOS transistor. However, obviously, it is possible to construct a non-complementary type configuration, that is a configuration with either the n-channel MOS transistor 840A alone or the p-channel MOS transistor 840B alone, three-dimensionally using the (100) plane and the (110) plane as described above. Also, unsurprisingly, such a configuration with either the n-channel MOS transistor or the p-channel MOS transistor can achieve the same effect as described above.

As above, the 1/f noise is reduced by evenly forming the silicon oxide film on any plane orientation by the plasma processing device 100, the channel length modulation effect is reduced by forming a gate on a plurality of plane orientations to make a transistor of a three-dimensional configuration, and therefore favorable electrical characteristics without variation between elements can be obtained. Also, the above three-dimensional configuration enables reduction of the element area.

A mixer circuit to which a MOS transistor with the above three-dimensional configuration, comprising a thin film gate insulator formed using the above gate insulator thin film formation method, is described below.

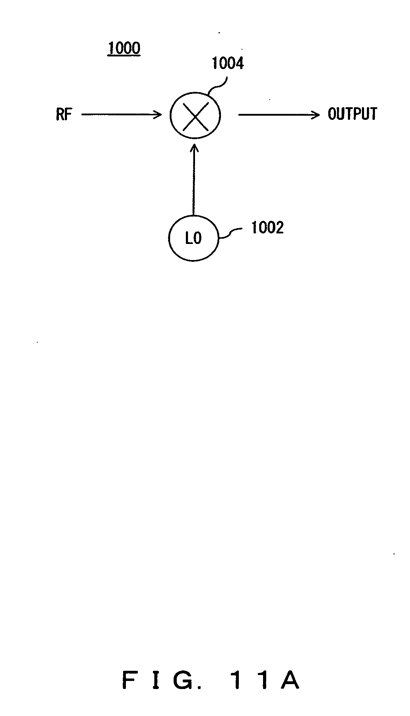

Fig. 11A is a block diagram of a frequency converter circuit comprising a mixer. A frequency converter circuit 1000 shown in Fig. 11A comprises a local oscillator 1002 for outputting a local signal, and a mixer 1004 for multiplying an RF signal input and the local signal input and for outputting the RF signal after frequency conversion to an intermediate frequency and a base band, for example.

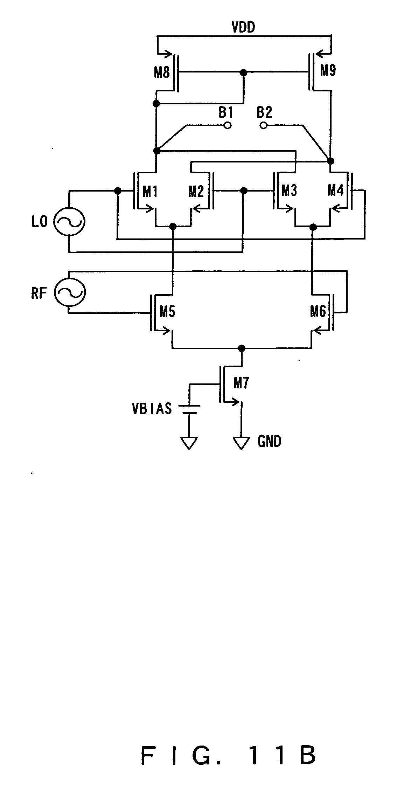

Fig. 11B is an example of an internal circuit of the mixer 1004.
For the configuration of the mixer 1004, there are a single balanced mixer with a configuration of an RF signal as a single-phase input and an LO signal as a differential input and a double balanced mixer with a configuration of both the RF signal and the LO signal as differential inputs etc.; however, as a circuit configuration of the present embodiment, a mixer circuit comprised of a Gilbert cell, which is a double balanced mixer, is shown. In the present embodiment, an n-channel MOS transistor is adopted as an example; however, a p-channel MOS transistor or both an n-channel MOS transistor and a p-channel MOS transistor can also be used. Although it is not specifically shown in the figures, the mixer circuit can be configured using a CMOS transistor.

The mixer circuit in Fig. 11B is configured by connecting two pairs of differential pair transistors M1-M4 for inputting an LO signal, a pair of differential pair transistors M5 and M6 for inputting an RF signal and active loads M8 and M9 with the constant current characteristic of a current mirror in a linear array.

In the transistors M5 and M6, the source of those transistors is grounded via a transistor M7 (constant current source), to which a bias voltage VBIAS is provided, and an RF signal is input as a differential input to each gate.

In the transistors M1, M2, M3 and M4, the sources of the transistors M1 and M2 are connected to the drain of M5, the sources of the transistors M3 and M4 are connected to the drain of M6, and the LO signal is input as a difference input to the connection point of the gates of M1 and M4 and to the connection point of the gates of M2 and M3.

In the active loads M8 and M9, the drain of the active load M8 is connected to the drains of the transistors M1 and M3, the drain of the active load M9 is connected to the drains of the transistors M2 and M4, and the gates of the active loads M8 and M9 are connected to each other. And the connection point of these gates is connected to the drain of the active load M8, and the source of the active loads M8 and M9 is connected to a power source VDD.

A first mixed output terminal B1 is configured on the drain of the transistors M1 and M3, and at the same time a second mixed output terminal B2 is configured on the drain of the transistors M2 and M4.
As in Fig. 11B, the n-channel MOS transistors are arranged so that the circuit has a symmetrical configuration.

The circuit constitutes a mixer circuit in which frequency conversion is applied to an RF signal by inputting an LO signal and the RF signal, and the signal of which the frequency is converted is output from a mixed output terminal. For example, when the frequencies of the LO signal and the RF signal are substantially different, an intermediate frequency (IF) signal is output from the mixed output terminal, whereas when the frequencies of the LO signal and the RF signal are the same, a base band signal is output from the mixed output terminal.

Each transistor element constituting the circuit is formed so that high-performance electrical characteristics, without variation can be acquired. For that reason, the 1/f noise generated in each transistor can be considerably reduced, and thus the noise of the output signal is kept low.

In addition, DC offset of the signals output from the differential pair transistors can be controlled, because each transistor element have less variation in their electrical characteristics.
Moreover, in the described circuit, the transistors are arranged so that the whole circuit has a symmetrical configuration; therefore, not only reduction of signal distortion by the channel length modulation effect in each transistor element but also output of a high quality mixed signal with little distortion from a mixed signal terminal can be achieved.

The above circuit configuration is the most preferred embodiment; however, as long as a mixer circuit comprises at least one MOS transistor with a three-dimensional configuration, the above-described effect can be obtained for reduction of the 1/f noise and reduction of the channel length modulation effect.

For DC offset, it is desirable to configure the transistor with differential pairs; however, if differential pair transistors are configured in the stage where the LO signal or the RF signal is input, for example, the above-described effect can be also acquired.

Though it is not specifically shown in the figures, the mixer circuit used for a receiver can be adopted as the mixer circuit used for a transmitter, and the above-described effect can be acquired is such a case as well.
As described above, the mixer circuit of the embodiment of the present invention comprises a circuit configuration in which 1/f noise generated from the transistor element, DC offset caused by variation in electrical characteristics of each of the transistor elements and generation of signal distortion owing to the channel length modulation effect are substantially reduced in a mixed output signal such as an IF signal and a base band signal output from the mixer circuit.

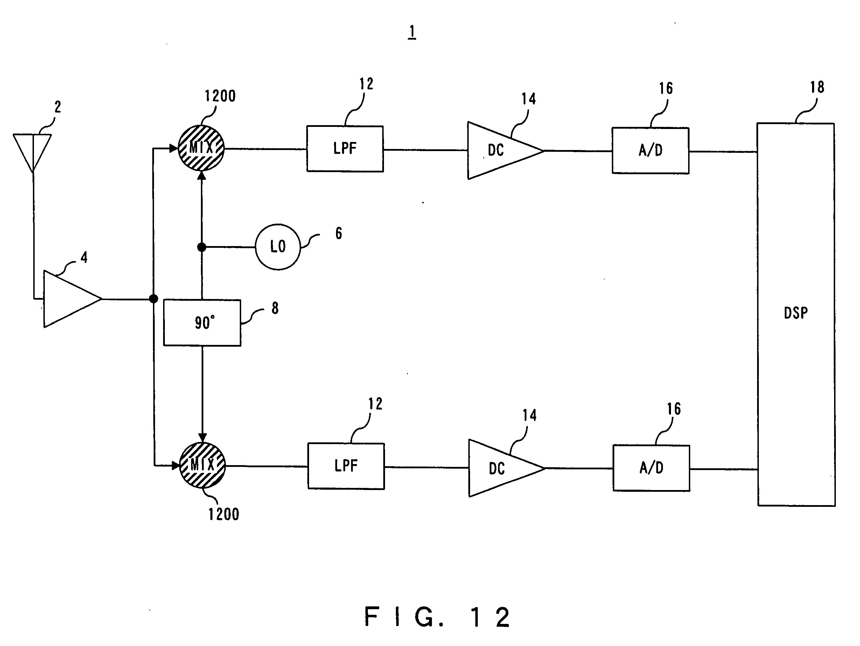

Fig. 12 is an example where the mixer circuit is applied to a circuit of the direct conversion receiving system. As shown in Fig. 12, the mixer circuit 1200 of the embodiment of the present invention can be inserted in the position of the mixer circuit 10 explained in the Background Art (the explanation of the configuration and the operation of the direct conversion receiving system is omitted as the detailed explanation was provided in the Background Art with reference to Fig. 1).

In such a way, by configuring the mixer circuit of the embodiment of the present invention in a direct conversion receiving system, in which the frequencies of the LO signal and the RF signal mixed in the mixer circuit are the same, dynamic range, which is a problem in conventional direct conversion receiving systems, can be effectively utilized in an A/D converter in a later stage. Additionally, the DC offset, the 1/f noise and the signal distortion are reduced, and thus it is possible to enhance the quality of the signal demodulated by the direct conversion receiving system.

It is obvious that because the above transistor has a three-dimensional configuration, the element area can be reduced, realizing a high-density semiconductor integrated circuit, and likewise, the IC of a mixer circuit or a direct conversion receiving system to which the transistor is applied can be also reduced in size.

As described above, according to the embodiment of the present invention, it is possible to substantially reduce the 1/f noise generated in transistor elements configured in a mixer circuit, the DC offset generated in an output signal due to variation in electrical characteristic of the transistor elements, and signal distortion based on the channel length modulation effect even in the case that transistors are integrated on a semiconductor substrate.

It is also possible to implement a mixer circuit as a CMOS configuration using transistors of the above configuration, allowing high quality of the output signal as well as downsizing of the mixer circuit and low electrical power consumption.
Furthermore, the use of the above mixer circuit in the direct conversion receiving system enables effective utilization of dynamic range in an A/D converter in a later stage, allowing acquisition of a high-quality demodulated signal and downsizing of the receiver.

The present invention is to be construed as embodying many variations without departing from the scope and spirit thereof. Accordingly, it is to be understood that descriptions herein are proffered by way of example to facilitate comprehension of the invention and should not be construed to limit the scope. The scope of the present invention is presented by the scope of claims and should not be limited by the descriptions. In addition, all modifications and alternative constructions, which fall into the equivalents of the scope of the claims, fairly fall within the scope of the present invention.

## Claims

1. A mixer circuit, comprising at least a differential pair transistors for inputting a first frequency signal or a second frequency signal and generating a third frequency signal by multiplying the first frequency signal and the second frequency signal, wherein each transistor of the differential pair transistors is a MIS transistor comprising:
a semiconductor substrate for comprising a first crystal plane as a principal plane;
a semiconductor structure, formed as a part of the semiconductor substrate, for comprising a pair of sidewall planes defined by the second crystal plane different from the first crystal plane and a top plane defined by the third crystal plane different from the second crystal plane;
a gate insulator of uniform thickness for covering the principal plane, the sidewall planes and the top plane;
a gate electrode for continuously covering the principal plane, the sidewall planes and the top plane on top of the gate insulator; and
a single conductivity type diffusion region formed in one side and the other side of the gate electrode in the semiconductor substrate and the semiconductor structure and continuously extending along the principal plane, the sidewall planes and the top plane.

2. A mixer circuit, comprising at least a differential pair transistors for inputting a first frequency signal or a second frequency signal and generating a third frequency signal by multiplying the first frequency signal and the second frequency signal, wherein each transistor of the differential pair transistors is a MIS transistor comprising:
a semiconductor substrate comprising a projecting part, of which the surfaces are at least two different crystal planes on a principal plane;
a gate insulator for covering at least a part of each of said at least two different crystal planes constituting the surface of the projecting part;
a gate electrode comprised by the gate insulator so as to be electrically insulated from the semiconductor substrate, and comprised on each of said at least two different crystal planes constituting the surface of the projecting part; and
a single conductivity type diffusion region formed in the projecting part facing each of said at least two different crystal planes constituting the surface of the projecting part and individually formed in both side of the gate electrode.

3. A mixer circuit, comprising at least a differential pair transistors for inputting a first frequency signal or a second frequency signal and generating a third frequency signal by multiplying the first frequency signal and the second frequency signal, wherein each transistor of the differential pair transistors is a three-dimensional MIS transistor, comprising:
a semiconductor substrate comprising at least two crystal planes;
a gate insulator formed on at least two of the crystal planes of the semiconductor substrate; and
a gate electrode formed on the semiconductor substrate sandwiching the gate insulator,
in which when voltage is applied to the gate electrode, a channel width of a channel formed in the semiconductor substrate along with the gate insulator is represented by summation of each channel width of the channels individually formed on said at least two crystal planes.

4. The mixer circuit according to any of claim 1 to claim 3, wherein the MIS transistor is **characterized in:**
**that** the semiconductor substrate is a silicon substrate; and
**that** a gate insulator on a surface of the silicon substrate, is formed by removing hydrogen in such a way that the surface of the silicon substrate is exposed to plasma of a prescribed inert gas, and the hydrogen content at the interface of the silicon substrate and the gate insulator is 10¹¹/cm² or less in units of surface density.

5. The mixer circuit according to claim 4, wherein said at least two crystal planes are any two different crystal planes from a (100) plane, a (110) plane and a (111) plane.

6. The mixer circuit according to claim 1 wherein the mixer circuit is a Gilbert cell type circuit.

7. The mixer circuit according to either claim 1 or claim 3, wherein the circuit configuration of the mixer circuit is using the MIS transistors symmetrically.

8. The mixer circuit according to either claim 1 or claim 3, used as a receiver for the first frequency signal, which is a high-frequency signal, the second frequency signal, which is a local signal, and the third frequency signal, which is a low-frequency signal.

9. The mixer circuit according to claim 8 wherein the low-frequency signal is used in a direct conversion receiving system where the signal is a base band signal.

10. A mixer circuit, comprising a CMOS transistor configured in an n-channel MOS transistor and a p-channel MOS transistor, wherein at least one of the n-channel MOS transistor or the p-channel MOS transistor comprises the MIS transistor of the mixer circuit according to claim 1 or claim 3.

11. The mixer circuit according to claim 10 wherein element areas and current driving capacities of the p-channel MOS transistor and the n-channel MOS transistor closely agree with each other.
